## Europäisches Patentamt

## European Patent Office

## Office européen des brevets

(11) Veröffentlichungsnummer: **0 176 824**
**B1**

(12) **EUROPÄISCHE PATENTSCHRIFT**

(45) Veröffentlichungstag der Patentschrift:
**22.03.89**

(51) Int. Cl.⁴: **H 03 D 7/16**

(21) Anmeldenummer: **85111446.2**

(22) Anmeldetag: **10.09.85**

(54) Schaltungsanordnung zur Umsetzung einer Frequenz für Fernsehempfänger.

(30) Priorität: **14.09.84 DE 3433721**

(43) Veröffentlichungstag der Anmeldung:
**09.04.86 Patentblatt 86/15**

(45) Bekanntmachung des Hinweises auf die Patenterteilung:
**22.03.89 Patentblatt 89/12**

(84) Benannte Vertragsstaaten:
**BE CH DE FR GB IT LI LU NL**

(56) Entgegenhaltungen:
**EP-A- 0 024 763**
**DE-B- 1 142 631**
**FR-A- 2 130 425**
**FR-A- 2 494 945**
**FR-A- 2 513 055**
**JP-B-53 038 129**
**US-A- 3 801 915**

(73) Patentinhaber: **Deutsche Thomson-Brandt GmbH, Hermann-Schwer-Strasse 3 Postfach 1307, D-7730 Villingen-Schwenningen (DE)**

(72) Erfinder: **Maier, Gerhard, Reutestrasse 19, D-7735 Dauchingen (DE)**
Erfinder: **Fischer, Bertram, Reuteweg 17, D-7212 Deisslingen (DE)**

ACTORUM AG

## Beschreibung

Die Erfindung geht aus von einer Schaltungsanordnung zur Umsetzung einer einem Fernsehempfänger zugeführten nicht im Empfangsbereich des Empfängers liegenden Eingangsfrequenz in eine in seinem Empfangsfrequenzbereich liegende Frequenz mit Hilfe einer Oszillatorstufe und einer Mischstufe sowie mit einem vor der Mischstufe angeordneten Bandfilter.

Es ist bekannt, bei Empfangsanlagen eine Anordnung vorzusehen, die eine mit einem Empfänger direkt nicht empfangbare Frequenz in eine Frequenz umsetzt, die der Empfänger verarbeiten kann. So gibt es z.B. UHF/VHF-Umsetzer, die ein im UHF-Frequenzbereich ausgesendetes Signal für einen Empfänger, der nur für den Empfang für VHF-Signale geeignet ist, derart aufbereiten, dass durch Umsetzung des UFH-Signals in ein VHF-Signal das UHF-Signal demoduliert werden kann. Eine derartige Anordnung besitzt für jeden Kanal im UHF-Bereich ein fest abgestimmtes Bandfilter, so dass der Aufwand für einen einzelnen Empfänger viel zu hoch ist. Deshalb findet man solche Anordnungen zumeist in Gemeinschaftsantennenanlagen, an welche sehr viele Empfänger angeschlossen sind.

Für das Kabelfernsehen (CATV) wurden Sonderkanäle S1–S10 eingeführt, die im Frequenzbereich von 150 MHz bis 170 MHz zwischen dem UKW-Band II und dem Fernsehband III liegen, sowie Sonderkanäle S11–S20, die im Frequenzbereich von 235 MHz bis 300 MHz zwischen den Fernsehbändern III und IV liegen. In die noch verbleibende Lücke zwischen dem Sonderkanal S20 und Band IV wurden in der Zwischenzeit zusätzliche Kanäle für eine Erweiterung des CATV-Bandes vorgesehen, die zwischen 300 MHz und 440 MHz liegen.

Der Erfindung liegt die Aufgabe zugrunde, Fernsehempfänger ohne Eingriff in die vorhandene Empfängerschaltung für diese zusätzlichen Sonderkanäle verfügbar zu machen, wobei gleichzeitig die heute gültigen FTZ-Vorschriften bezüglich Störstrahlung und Störsenderunterdrückung eingehalten werden sollen. Diese Aufgabe wird durch die im Patentanspruch angegebene Erfindung gelöst.

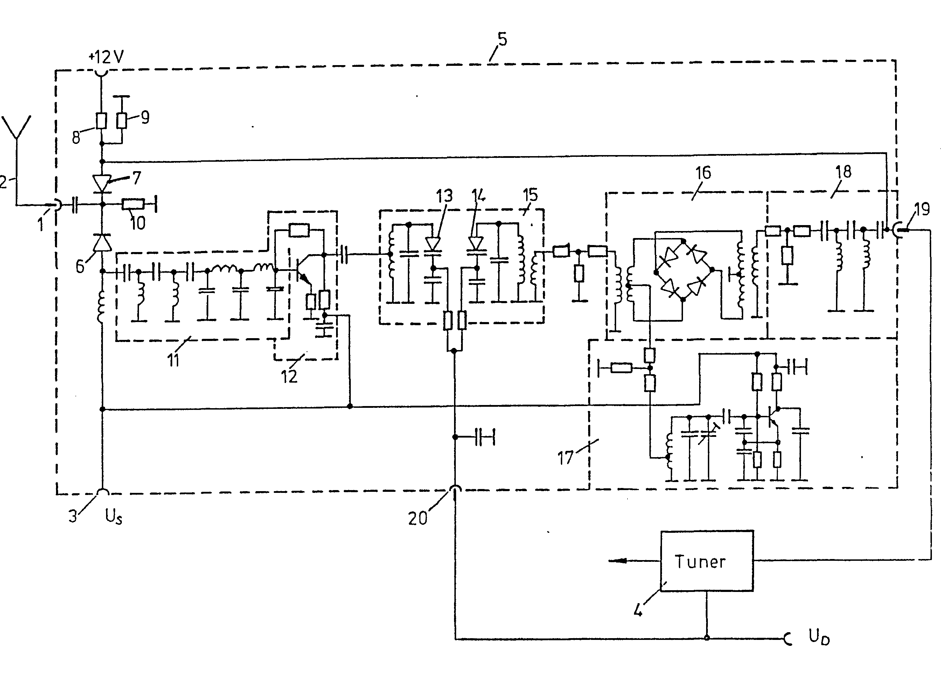

Nachstehend sei die Erfindung an einem Ausführungsbeispiel mit Hilfe der Zeichnung beschrieben.

An den Eingang 1 der Schaltungsanordnung ist die Antenne 2 für das Empfangsgerät angeschlossen. Das Antenneneingangssignal wird je nach einer auf den Eingang 3 gegebenen Information in Form einer Schaltspannung US entweder direkt an den Eingang des Tuners 4 im Fernsehempfänger geschaltet oder über die noch zu beschreibende Schaltungsanordnung 5 geleitet. Hierzu dienen die Schaltdioden 6 und 7. Die Diode 7 ist über den Spannungsteiler 8 und 9 positiv vorgespannt, so dass diese durchgeschaltet ist, wenn am Eingang 3 z.B. Null Volt anliegt. Die Diode 6 ist gesperrt, so dass das Signal vom Eingang 1 über die durchgeschaltete Diode 7 an den Tuner 4 gelangen kann. Wird auf den Eingang 3 z.B. eine positive Schaltspannung US gegeben, die grösser ist als die am Widerstand 10 liegende über den Spannungsteiler 8, 9 erzeugte, wird die Diode 7 gesperrt und die Diode 6 in Durchlassrichtung vorgespannt, so dass das Antennensignal über die Schaltungsanordnung 5 zur Frequenzumsetzung geleitet wird. Hierzu erreicht das Antennensignal zunächst einen Bandpass 11, der Frequenzen im Bereich von 300 MHz bis 440 MHz überträgt. Von dort gelangt das Signal an einen Verstärker 12. Der Verstärker 12 ist an ein mittels Kapazitätsdioden 13 und 14 abstimmbares Bandfilter 15 angeschlossen, welches an einen Eingang einer Mischstufe 16 geschaltet ist. An den anderen Eingang dieser Mischstufe 16 ist ein Festfrequenzoszillator 17 geschaltet. Das Mischprodukt gelangt über einen Hochpass 18 an den Ausgang 19 der Schaltungsanordnung 5 und von dort aus an den Tuner 4. Der Oszillator 17 ist auf eine Frequenz fest eingestellt, die mit der Eingangsfrequenz mit Hilfe der Mischstufe 16 eine im UHF-Bereich des Tuners liegende Frequenz erzeugt. Der Tuner 4 ist mit Hilfe einer Abstimmspannung UD auf eine gewünschte UHF-Frequenz abgestimmt, die zum Empfang des gewählten Sonderkanals dient. An den Eingang 20 der Schaltungsanordnung 5 wird ebenfalls die dem Tuner zu seiner Abstimmung dienende Spannung UD zugeführt. Die Abstimmung für das Bandfilter 15 geschieht im Gleichlauf zur Tunerabstimmung. Wenn der Tuner durch eine vorgegebene Abstimmspannung UD auf eine bestimmte Frequenz im UHF-Bereich abgestimmt ist, so ist das Bandfilter 15 in dem Frequenzumsetzer 5 durch diese gleiche Abstimmspannung auf eine Frequenz abgestimmt, die der zu empfangenden Frequenz entspricht, die nach Mischung mit der festen Oszillatorfrequenz des Oszillators 17 die im Tuner eingestellte Frequenz ergibt. Durch diese Massnahme werden Störsender eliminiert, da das Bandfilter 15 jeweils auf die Empfangsfrequenz mit der gerade notwendigen Bandbreite abgestimmt ist.

Bezugszeichenliste

1   Eingang
2   Antenne
3   Schaltspannungseingang
4   Tuner
5   Frequenzumsetzer
6   Diode
7   Diode
8   Widerstand
9   Widerstand
10  Widerstand
11  Bandfilter
12  Verstärker
13  Kapazitätsdiode
14  Kapazitätsdiode
15  Bandfilter
16  Mischstufe
17  Oszillator
18  Hochpass

19 Ausgang
20 Eingang f. Abstimmspannung

## Patentanspruch

1. Schaltungsanordnung zur Umsetzung einer einem Fernsehempfänger zugeführten nicht im Empfangsfrequenzbereich des Empfängers liegenden Eingangsfrequenz in eine in seinem Empfangsfrequenzbereich liegende Frequenz mit Hilfe einer Oszillatorstufe (17) und einer Mischstufe (16), sowie mit einem vor der Mischstufe angeordneten Bandfilter (15), dadurch gekennzeichnet, dass der Oszillator (17) des Frequenzumsetzers (5) auf eine solche unterhalb des Empfangsbereichs liegende Frequenz fest eingestellt ist, dass das Mischprodukt am Ausgang der Mischstufe (16) derart im UHF-Frequenzbereich des Fernsehempfängers liegt, dass bei der fest eingestellten Oszillatorfrequenz des Frequenzumsetzers (5) die Abstimmung des Bandfilters (15) von der Abstimmspannung des auf die umgesetzte Empfangsfrequenz abgestimmten Fernsehempfänger-Tuners (4) im Gleichlauf mit den Bandfiltern im Fernsehempfänger-Tuner (4) gesteuert wird.

## Revendication

1. Montage pour convertir une fréquence d'entrée envoyée à un récepteur de télévision et non située dans la gamme des fréquences de réception du récepteur, en une fréquence située en cette gamme de fréquences, à l'aide d'un étage oscillateur (17) et d'un étage mélangeur (16), avec un filtre passe-bande (15) disposé en amont de l'étage mélangeur, caractérisé par le fait que l'oscillateur (17) du convertisseur de fréquence (5) est réglé de façon fixe sur une fréquence située au-dessous de la gamme de réception et telle que le produit mixte présent sur la sortie de l'étage mélangeur (16) est situé dans la gamme des ultra-hautes fréquences du récepteur de télévision de sorte que, pour la fréquence réglée de façon fixe de l'oscillateur du convertisseur de fréquence (5), le réglage d'accord du filtre passe-bande (15) est commandé par la tension de réglage d'accord du synthoniseur (4) du récepteur de télévision, réglé sur la fréquence de réception convertie, en synchronisme avec les filtres passe-bande situés dans le synthoniseur (4) du récepteur de télévision.

## Claim

1. Circuit arrangement for converting an input frequency transmitted to a television receiver and not lying in the range of reception of the receiver into a frequency lying in its frequency range of reception, with the help of an oscillator stage and a mixer stage (16), and a band filter arranged before the mixer stage, characterised in that the oscillator (17) of the frequency converter (5) is fixedly set at such a frequency lying below the range of reception that the mixing product is in the UHF frequency range at the output of the mixer stage (16) in such a manner that with the fixedly set oscillator frequency of the frequency converter (5), the tuning of the band filter (15) is controlled by the tuning voltage of the television receiver tuner (4) tuned to the converted frequency of reception synchronously with the band filters in the television receiver tuner (4).